# EUROPEAN PATENT APPLICATION

(11) **EP 2 184 614 A2**
(43) Date of publication of application: **12.05.2010**
(21) Application number: 09175552.0
(22) Date of filing: 10.11.2009
(51) Int. Cl.: G01R 31/00

(54) **Systems and methods for charged device model electrostatic discharge testing**

(30) Priority: 11.11.2008 US 113308 P; 13.05.2009 US 465099
(71) Applicant: Thermo Fisher Scientific Inc., Waltham MA 02454 (US)
(72) Inventor: Hernandez, Marcos, San Jose, CA 95125 (US)
(74) Representative: Mackenzie, Andrew Bryan

(57) **Abstract**

Systems and methods for testing an integrated circuit device using transmission path and charged device model electrostatic discharge testing. The method includes measuring a electrostatic discharge signal (152) from a charged transmission path (56) of the system (10), measuring a electrostatic discharge signal (162) from the charged transmission path (56) of the system (10) and a charged integrated circuit device (12) coupled with the charged transmission path (56), and determining a charged device model waveform (182) based upon distinctions between these electrostatic discharge signals (152, 162).

## Description

### Cross-Reference to Related Applications

This application claims the benefit of U.S. Provisional Application No. 61/113,308, filed November 11, 2008, the disclosure of which is hereby incorporated by reference herein in its entirety.

### Background

The present invention relates to testing electronic circuits, and more particularly to systems and methods for charged device model electrostatic discharge testing.

Integrated circuits are the backbone of computers and most modem consumer electronics. In a typical integrated circuit fabrication, various semiconductor materials are formed into ingots generally comprised of nearly pure single crystal silicon, then sliced into wafers. Each wafer is typically processed through deposition, patterning, etching, and/or modification of electrical properties such that a plurality of chips is formed on the wafer. The chips are typically singulated from the wafer and packaged.

Despite advances in technology and power systems, integrated circuits often experience anomalous inputs (typically called "transients"), whether on power, input, output, or input/output ("I/O") pins, that can cause unexpected functionality, errors, failure, or even destruction of components of integrated circuits. These transients generally include electrostatic discharge, voltage spikes, voltage drops, current spikes, current drops, electromagnetic radiation, and other electrical noise. Integrated circuits are generally designed to withstand some amount of these transients such that the transients neither produce erroneous results nor cause failure of the integrated circuit.

Typical integrated circuits include one or more internal transient protection circuits that attempt to reduce or eliminate the effects of transients on the integrated circuit. However, these transient protection circuits may fail, and thus it is often desirable to determine the response of chips, wafers, and/or other electronic or integrated circuit devices to transients both before and after packaging. As such, testing is often used after various processing and/or packaging steps to test the response of integrated circuit devices to transients, such as electrostatic discharge ("ESD").

Conventional ESD testing often includes human body model ("HBM") testing and machine model ("MM") testing to test the susceptibility of integrated circuit devices to ESD from an analog of human contact or a charged conductive object, respectively. Additionally, conventional ESD testing often includes charged device model ("CDM") testing to test the transfer of charge from an integrated circuit device. The transfer of charge from some integrated circuit devices is typically more destructive than an HBM ESD.

One new type of CDM testing typically includes inserting a packaged integrated circuit device into a socket, charging the socket and integrated circuit device, and then discharging the charged integrated circuit device. However, this socketed discharge model ("SDM") testing may provide unstable results, as the capacitance of the socket, capacitance of the pins of the packaged integrated circuit device, and/or the low predictability of the amplitude of power signals from the socket and/or tester often skews waveforms and distorts ESD measurements. Moreover, SDM testing is often inefficient with respect to testing integrated circuit devices disposed on wafers, integrated circuit devices disposed on portions of wafers, and/or integrated circuit devices that have been singulated into chips, as there is frequently no way to socket those integrated circuit devices until they are packaged.

One additional type of CDM testing typically includes inducing a field charge on an integrated circuit device. In field induced charged device model ("FICDM") testing, an integrated circuit device disposed in a package is typically charged by a field plate and contacted by a discharge head that often supports a ground plane. The ESD transmitted to the discharge head is typically measured to determine the FICDM ESD response of the integrated circuit device. However, the FICDM testing may provide unstable results, as the capacitance between the field plate and ground plane, the effects of air on the ESD, the effects of moisture on the ESD, the approach speed of the discharge head to the integrated circuit device, and/or the low predictability of the actual charge on the integrated circuit device often skews waveforms and distorts ESD measurements.

Consequently, there is a need to improve CDM ESD testing of an integrated circuit device, and particularly a continuing need to test the integrated circuit device with a system that alleviates the problems inherent in conventional CDM ESD testing systems.

### Summary

Embodiments of the invention address these and other deficiencies in the art by providing a method and system for testing an integrated circuit device that utilizes a transmission path and charged device model ("TPCDM") electrostatic discharge testing. The method, in one embodiment, includes measuring a first electrostatic discharge signal from a charged transmission path, measuring a second electrostatic discharge signal from the charged transmission path and a charged integrated circuit device coupled with the charged transmission path, and determining a charged device model (CDM) waveform based upon the first and second electrostatic discharge signals. The method may comprise charging the transmission path, discharging the transmission path and in response to discharging the transmission path, measuring the first electrostatic discharge signal. The transmission path may be charged for a time greater than 50 ms and the transmission path and the integrated circuit device may be charged for a time greater than 50 ms.

In another embodiment, a system is provided to test an integrated circuit device. The system may include first and second electrically conductive plates each in electrical communication with electrical ground, a probe pin in electrical communication with a transmission path to electrically communicate with the integrated circuit device, and a support arm operable to electrically couple the probe pin to the integrated circuit device. The first electrically conductive plate is configured to support the integrated circuit device. The support arm is configured support the second electrically conductive plate and the probe pin. The system further includes a controller coupled with the probe pin and support arm, the controller configured to charge the transmission path of the system, discharge the transmission path, and measure a first electrostatic discharge signal, to move the support arm to electrically couple the integrated circuit device with the transmission path, charge the transmission path and the integrated circuit device, discharge the transmission path and the integrated circuit device, and measure a second electrostatic discharge signal from which the first electrostatic discharge signal can be removed to determine a charged device model (CDM) waveform. The system may include a high voltage power supply unit and a switch configured to selectively couple the high voltage power supply unit with the transmission line, the switch having a first position for electrically connecting the transmission path with the high voltage power supply unit to charge the transmission path and a second position in which the transmission line is disconnected from the high voltage power supply unit to discharge the transmission path for measuring the first and second electrostatic discharge signals. The impedance of the switch may be approximately equal to the impedance of the transmission path. The system may include an oscilloscope coupled by the switch in the second position to define a signal line with the transmission path, the oscilloscope being configured to determine the wave form by removing the first electrostatic discharge signal from the second electrostatic discharge signal. Optionally at least one attenuator may be provided in the signal line between the oscilloscope and the switch. The controller may be coupled by the switch in the second position with the transmission path, the controller being configured to determine the wave form by removing the first electrostatic discharge signal from the second electrostatic discharge signal. Optionally at least one attenuator may be provided in the signal line between the oscilliscope and the switch, and a resistor may be provided in the signal line between the at least one attentuator and the controller. The transmission path may be a co-axial cable including a core and a shield surrounding the core, the shield of the co-axial cable being connected in electrical communication with electrical ground, and the first electrically conductive plate being in electrical communication with the shield.

These and other advantages will be apparent in light of the following figures and detailed description.

### Brief Description of the Drawings

The accompanying drawings, which are incorporated in and constitute a part of this specification, illustrate embodiments of the invention and, together with a general description of the invention given above and the detailed description of the embodiments given below, serve to explain the principles of the invention.

FIG. 1 is block diagram of an integrated circuit device testing system to test an integrated circuit device utilizing transmission path discharge charged device model testing consistent with embodiments of the invention;

FIG. 1A is a block diagram similar to FIG. 1 in which the controller receives the electrostatic discharge signals and determines the charged device model (CDM) waveform;

FIG. 2 is a diagrammatic illustration of one embodiment of a probe head of the system of FIG. 1 that supports a solid top ground plate and a probe pin to electrically connect the system to the integrated circuit device;

FIG. 3 is a diagrammatic illustration of an alternative embodiment of the probe head of FIG. 2 that supports a wire screen top ground plate and the probe pin to electrically connect the system to the integrated circuit device;

FIG. 4 is a flowchart illustrating a process to determine a base waveform that includes the electrostatic discharge of a charged transmission path of the system when that transmission path is not connected to the integrated circuit device consistent with embodiments of the invention;

FIG. 5 is a flowchart illustrating a process to determine a transmission path discharge and charged device model waveform that includes the electrostatic discharge of the charged transmission path discharge and the electrostatic discharge of the charged integrated circuit device consistent with embodiments of the invention;

FIG. 6 is a flowchart illustrating a process to determine a charged device model waveform that includes the electrostatic discharge of the charged integrated device consistent with embodiments of the invention;

FIG. 7 is a diagrammatic illustration of the base waveform of FIG. 4;

FIG. 8 is a diagrammatic illustration of the transmission path discharge and charged device model waveform of FIG. 5;

FIG. 9 is a diagrammatic illustration of the relationship between the base waveform of FIG. 4, the transmission path discharge and charged device model waveform of FIG. 5, and the charged device model waveform of FIG. 6; and

FIG. 10 is a diagrammatic illustration of the charged device model waveform of FIG. 6.

It should be understood that the appended drawings are not necessarily to scale, presenting a somewhat simplified representation of various preferred features illustrative of the basic principles of the invention. The specific design features of the sequence of operations as disclosed herein, including, for example, specific dimensions, orientations, locations, and shapes of various illustrated components, will be determined in part by the particular intended application and use environment. Certain features of the illustrated embodiments may have been enlarged or distorted relative to others to facilitate visualization and clear understanding.

### Detailed Description

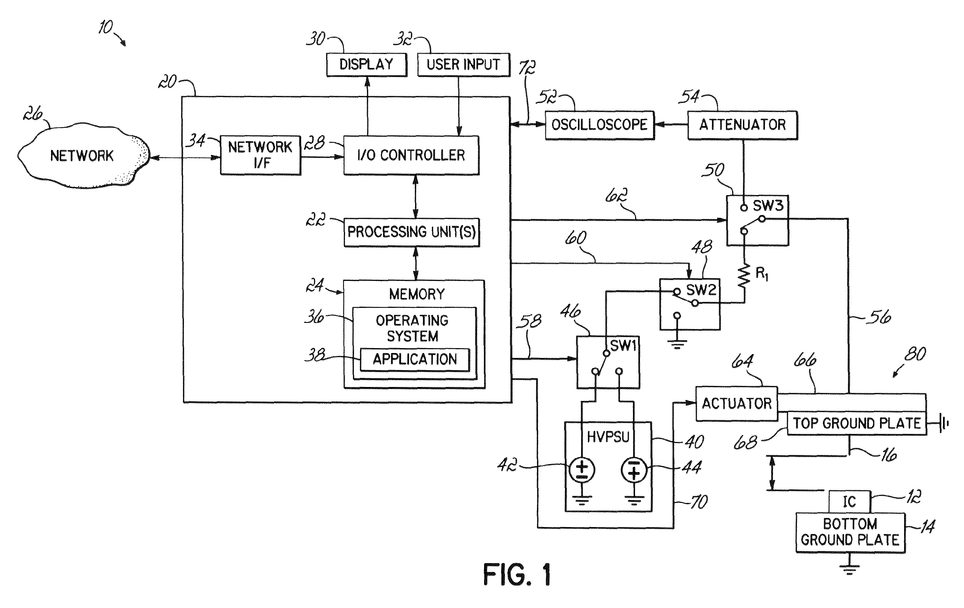

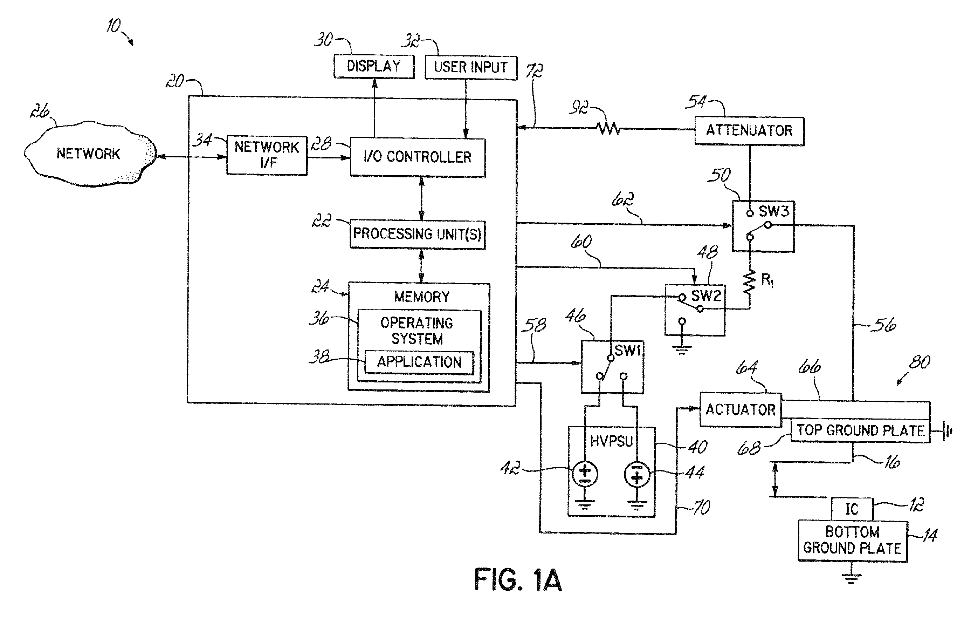

Turning to the drawings, wherein like numbers denote like parts throughout the several views, FIG. 1 is a diagrammatic illustration of one embodiment of an integrated circuit device testing system 10 (hereinafter, "system 10") operable to test an integrated circuit device 12 (shown as, and hereinafter, "IC" 12). In some embodiments, the system 10 is transmission path operable to determine charged device model ("CDM") electrostatic discharge ("ESD") signals similar to those use in field induced charge device model ("FICDM") testing without the uncertainties associated with air gaps, moisture problems, probe pin distance issues, stray capacitance of sockets and pins, and/or configuration issues that occur when testing integrated circuit devices that are not disposed in packaging, among others, that may arise in FICDM testing. In specific embodiments, the system 10 may be configured to perform a transmission path and CDM ("TPCDM") ESD test to determine the CDM response of the IC 12 by measuring a transmission path ESD signal from a charged transmission path, measuring a transmission path and charged integrated circuit device ESD signal from the charged transmission path and a charged integrated circuit device, and determining a charged device ESD signal based upon the measured electrostatic discharge signal for the transmission path alone and the measured electrostatic discharge signal for both the transmission path and charged device.

In various embodiments, the IC 12 may be a semiconductor wafer, a portion of a semiconductor wafer, a chip on a semiconductor wafer, an exposed integrated circuit device, or an integrated circuit device disposed within packaging. In the latter embodiment, the IC 12 may be in dielectric packaging and in electrical connection with plurality of pins, connections points, or solder balls that variously extend through the packaging or are configured outside of the packaging. During testing, the IC 12 may be configured on a bottom ground plate 14.

During testing, the IC 12 may be in electrical communication with the system 10 through a probe pin 16. In the embodiments where the IC 12 is disposed within packaging, the IC 12 is configured in a "dead bug" position (e.g., the IC 12 may be configured with its pins, connection points, or solder balls "up") on the bottom ground plate 14. In alternative embodiments where the IC 12 is disposed on a wafer, a portion thereof, a chip thereof, and/or where the IC 12 is an exposed integrated circuit device, the IC 12 is configured on the bottom ground plate 14 such that the system 10 may be in electrical communication with the IC 12 through the probe pin 16.

The system 10 includes a controller 20 to control the TPCDM testing of the IC 12 as well as other operations of the system 10. The controller 20 typically includes at least one processing unit 22 communicating with a memory 24. The processing unit 22 may be one or more microprocessors, micro-controllers, field-programmable gate arrays, or ASICs, while memory 24 may include random access memory (RAM), dynamic random access memory (DRAM), static random access memory (SRAM), flash memory, and/or another digital storage medium. As such, memory 24 may be considered to include memory storage physically located elsewhere in controller 20, e.g., any cache memory in the at least one processing unit 22, as well as any storage capacity used as a virtual memory, e.g., as stored on a mass storage device, a computer, or another controller coupled to controller 20 by way of a network 26. In specific embodiments, the controller 20 may be a computer, computer system, computing system, server, disk array, or programmable device such as a multi-user computer, a single-user computer, a handheld device, a networked device, or other programmable electronic device. As such, the controller 20 may include an I/O controller 28 in communication with a display 30 and user input device 32 to display information to a user and receive information from the user, respectively. The I/O controller 28 may be further in communication with a network interface 34 (illustrated as "Network I/F" 34) that is in turn in communication with the network 26. The controller 20 may also include an operating system 36 to run program code 38 (illustrated as "Application" 38) to control the system 10 and/or TPCDM testing.

To test the IC 12, the system 10 may generate a first voltage signal, then apply it to a transmission path and measure the ESD of the charged transmission path to determine a base waveform (e.g., a transmission path ESD signal) transmission path for the system 10. Subsequently, the system 10 may electrically connect to the IC 12, generate a second voltage signal, apply the second voltage signal to the transmission path and the IC 12, then measure the ESD of the charged transmission path and the charged IC to determine a transmission path discharge ("TLD") and charged device model ("CDM") waveform (e.g., a transmission path and charged IC ESD signal) for the system 10. Then, a CDM waveform (e.g., a charged IC ESD signal) may be determined based upon the base waveform and the TLD and CDM waveform (hereinafter, the "TLD/CDM" waveform). To generate the voltage signals, the system 10 may include at least one high voltage power supply unit 40 (illustrated as, and hereinafter, "HVPSU" 40) that may in turn include at least one positive voltage source 42 and at least one negative voltage source 44 (collectively, the "voltage sources" 42, 44) to generate respective positive and negative high voltage signals. The positive voltage source 42 may be configured to provide a positive voltage signal from about 1V to about 2000V, while the negative voltage source 44 may be configured to provide a negative voltage signal from about -1V to about -2000V.

The system 40 may include a first switch 46 (illustrated as, and hereinafter, "SW1" 46) to switch between the voltage sources 42, 44, a second switch 48 (illustrated as, and hereinafter, "SW2" 48) to switch between the output from SW1 46 and a connection to an electrical ground, as well as a third switch 50 (illustrated as, and hereinafter, "SW3" 50) to switch between the output from SW2 48 connected to SW3 through resistor R1 and a signal path to an oscilloscope 52 through at least one attenuator 54. The output of SW3 50 may be in electrical communication with a transmission path 56, at least a portion of which may in turn be in electrical communication with the probe pin 16. In some embodiments, SW1 46, SW2 48, and SW3 50 are each a single-pole, double-throw ("SPDT") switch controlled by the controller 20 through control lines 58, 60, and 62. In some embodiments, the signal lines from the HVPSU 40 to SW1 46, from SW1 46 to SW2 48, from SW2 to SW3, from SW3 to the oscilloscope 52 and attenuator 54, and the transmission path 56 are coaxial cable as is well known in the art. As such, the core of the coaxial cables may be configured to transfer the signals from the HVPSU 40, SW1 46, SW2 48, and/or SW3 50, while the shields of the coaxial cables may be in electrical communication with electrical ground.

In some embodiments, the switches SW1, 46 and SW2 48 are high voltage switches configured to withstand at least 2000V, and in specific embodiments the switches SW1 46 and SW2 48 may be part no. 5501-24-1 SPDT switches as distributed by Coto Corporation, dba Coto Technology, of Providence, Rhode Island. In some embodiments, SW3 50 may be a high frequency switch with an impedance of about 50Ω configured to withstand at least 2000V, and, in specific embodiments, the switch SW3 may be a part no. 400-313A SPDT switch as distributed by Computer Components, Inc., of East Granby, Connecticut. In some embodiments, the transmission path 56 may be a coaxial cable with an impedance of about 50Ω. As such, the impedance of SW3 50 may be matched to the impedance of the transmission path 56. In some embodiments, the oscilloscope 52 may be a digital oscilloscope, and in specific embodiments the oscilloscope 52 may be model no. TDS694B 3GHz digital storage oscilloscope as distributed by Tektronix, Inc., of Beaverton, Oregon. In some embodiments, the at least one attenuator 54 may include two part no. 665-20-1-M01/BR 20dB attenuators as distributed by MECA Electronics, Inc., of Denville, New Jersey. In alternative embodiments, the at least one attenuator 54 may include five 8dB attenuators, four 10dB attenuators, one 40dB attenuator, and/or other combinations of attenuators to achieve a 40dB attenuation of the signal to the oscilloscope 52. In further alternative embodiments, the at least one attenuator 54 may be configured to provide more or less attenuation than 40dB, and in still further embodiments the at least one attenuator 54 may include at least one frequency attenuator and at least one power attenuator as is well known in the art.

To test the IC 12, the system 10 may be configured with an actuator 64 to move a support arm 66 that in turn may be configured to receive the transmission path 56 and hold the probe pin 16 during testing. The support arm 66 may further be configured to hold a top ground plate 68 electrically coupled to an electrical ground. In some embodiments, the top ground plate 68 is configured to shape the waveforms associated with CDM testing, and in specific embodiments the top ground plate 68 is configured to shape the electromagnetic field produced by the signals to and from the IC 12, the IC 12 itself, the signals through the probe pin 16, and the signals through the transmission patch 56. The top ground plate 68 may be electrically coupled to a shield 83 of the coaxial cable of the transmission path 56 or to a separate electrical ground. The controller 20 may control the operation of the actuator 64 through control line 70 to move the support arm 66 and electrically couple the probe pin 16 to, or electrically decouple the probe pin 16 from, the IC 12. Additionally, the controller 20 may control the operation of the oscilloscope 52 through control line 72. Thus, the controller 20 may provide a command for the oscilloscope 52 to capture and/or store a measurement, as well as a command for the oscilloscope 52 to transfer a captured measurement to the controller 20. In some embodiments, the controller 20 also receives information from the oscilloscope 52 through control line 72. As illustrated in FIG. 1, the probe pin 16, at least a portion of the support arm 66, and/or the top ground plate 68 may be configured as a probe head 80, or a portion thereof, for ESD testing consistent with embodiments of the invention.

Thus, in various embodiments, the controller 20 may be configured to control SW1 46, SW2 48, SW3 50, and the actuator 64 through respective control lines 58, 60, 62, and 70 to electrically couple the probe pin 16 and/or IC 12 to the positive voltage source 42, the negative voltage source 44, an electrical ground, or the oscilloscope 52 through attenuator 54. Moreover, the controller 20 may be configured to capture, store, and/or transfer measured signals from the transmission path 56 and/or IC 12 with the oscilloscope 52 through control line 72.

The system 10 also includes the resistor R1. The resistor R1 is configured to raise a potential at the IC 12 to a desired level. As such, the resistor R1 may be configured as a conventional resistor having a resistance from about 100MΩ to about 1GΩ such that the signal from the HVPSU 40 to charge the transmission path 56 and/or IC 12 has a low current. Advantageously, it is believed that by providing a low current to the IC 12, damage to the IC 12 is prevented prior to TPCDM testing. One having ordinary skill in the art will appreciate that the resistor R1 may have a larger or smaller value depending on the desired potential at the IC 12.

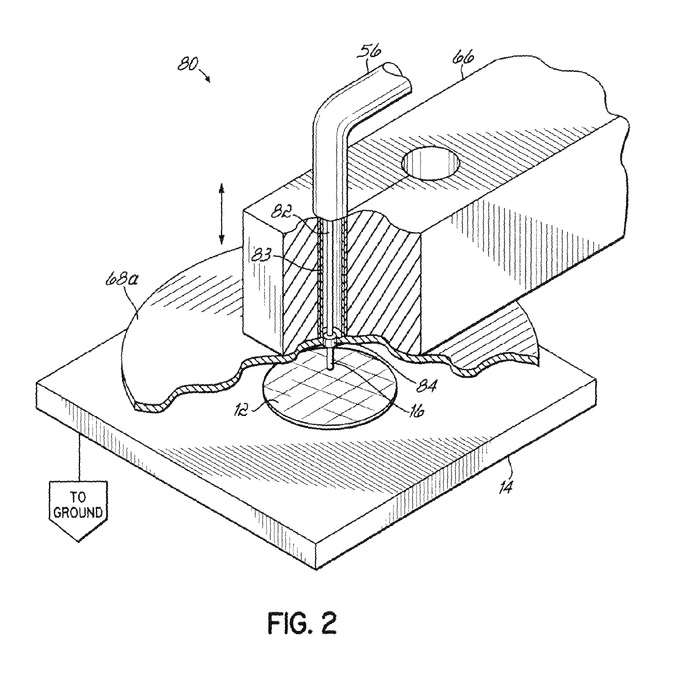

During at least a portion of TPCDM testing, the support arm 66 may be controlled by the actuator 64 to bring the probe pin 16 into contact, and thus electrical communication, with a contact point of the IC 12 (e.g., a contact point on a wafer, a portion thereof, chip thereof, an exposed integrated circuit device, and/or on a pin of an integrated circuit device disposed within packaging) such that at least one electrical connection is established between the IC 12 and the system 10. Conversely, during a least a portion of TPCDM testing, the support arm 66 may be controlled by the actuator 64 to move the probe pin 16 from the IC 12 to break an electrical connection between the IC 12 and the system 10. FIG. 2 is an enlarged diagrammatic illustration of one embodiment of the probe head 80 of the system 10 consistent with embodiments of the invention. As illustrated in FIG. 2, the IC 12 is disposed upon the bottom ground plate 14, which may be an electrically conductive solid plate in electrical communication with an electrical ground, but the IC 12 may not be in electrical communication with the bottom ground plate 14 itself.

Throughout the embodiments, the probe head 80 may include at least a portion of the support arm 66, which may in turn be configured to hold a coaxial cable of the transmission path 56 and be controlled by the actuator 64 to electrically connect the probe pin 16 and a contact point the IC 12. In addition, the support arm 66 may be controlled by the actuator 64 to break an electrical connection between the probe pin 16 and a contact point of the IC 12. As illustrated in FIG. 2, the IC 12 may be a semiconductor wafer, a portion of a semiconductor wafer, a chip on a semiconductor wafer, and/or an exposed integrated circuit device configured with at least one contact point suitable for the probe pin 16 to contact. In some embodiments, the probe pin 16 is electrically connected to the core of the coaxial cable 82 of the transmission path 56 through a one-ohm radial resistor 84 as is well known in the art. In specific embodiments, the probe pin 16 may be a spring-loaded Pogo pin as is also well known in the art.

As illustrated in FIG. 2, the top ground plate 68a may be an electrically conductive solid plate in electrical communication with an electrical ground. The top ground plate 68a may be coated with a layer of a nickel, gold, or nickel and gold plating. In some embodiments, the top ground plate 68a is in electrical communication with the electrically conductive shield 83 of the coaxial cable of the transmission path 56, while in alternative embodiments the top ground plate 68a is in electrical communication with a separate electrical ground. As illustrated, the top ground plate 68a may have a round cross-section and a circular perimeter characteristic of a disk geometrical shape when viewed in a direction normal to plate 68a. One having ordinary skill in the art will appreciate that the top ground plate 68a may alternatively be configured with a different cross-section, such as a triangular, square, pentagonal, or other cross-section as is well known in the art. During TPCDM testing, the top ground plate 68a is configured to shape the waveforms associated with TPCDM testing. In specific embodiments, the top ground plate 68a is configured to shape the electromagnetic field produced when the probe pin 16 and/or the IC 12 is charged, and/or the electromagnetic field produced when the probe pin and/or the IC 12 that has been charged is discharged. As illustrated in FIG. 2, the top ground plate 68a may have a larger cross-sectional area, or "footprint," than the IC 12. The probe pin 16 projects beyond a plane of the top ground plate 68a toward the bottom ground plate 14 and is electrically isolated from the top ground plate 68a.

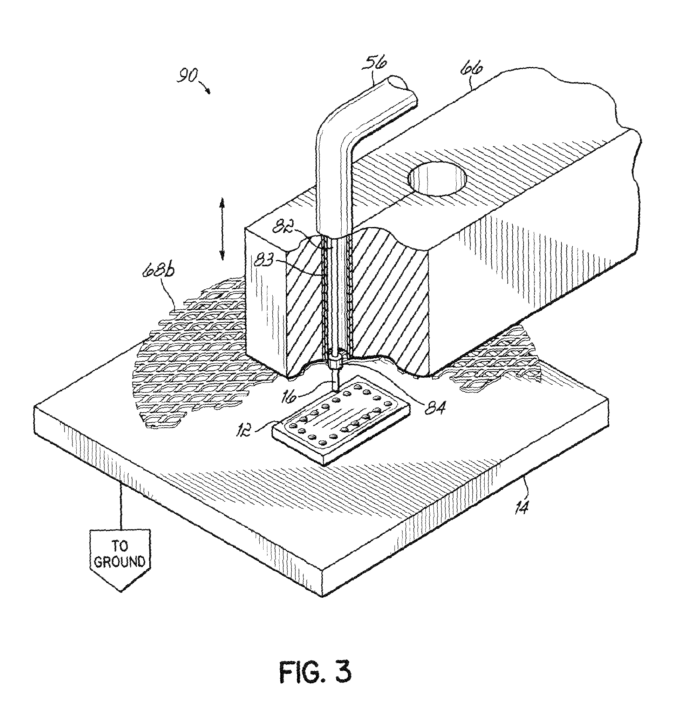

FIG. 3 is an enlarged diagrammatic illustration of an alternative embodiment of a probe head 90 of the system 10 consistent with alternative embodiments of the invention. Similarly to the probe head 80 of FIG. 2, FIG. 3 illustrates that probe head 90 is configured to hold the probe pin 16, which is in electrical communication with the core 82 of the coaxial cable of the transmission path 56 through a one-ohm radial resistor 84. The top ground plate 68b may also be in electrical communication with the shield 83 of the coaxial cable of the transmission path 56. However, as illustrated in FIG. 2, the IC 12 may be an integrated circuit device disposed within packaging and disposed on the bottom ground plate 14 in a "dead bug" configuration. Thus, the IC 12 may be configured with at least one contact point and suitable to be contacted by the probe pin 16. Also as illustrated in FIG. 3, the top ground plate 68b may be an electrically conductive wire screen in electrical communication with an electrical ground. In some embodiments, the top ground plate 68b is an electrically conductive screen, and in various embodiments the top ground plate 68b may be a steel screen, an iron screen, an aluminum screen, and/or a nickel, gold, or nickel and gold plated screen thereof. In specific embodiments, the top ground plate 68b is an electrically conductive wire screen having a plurality of substantially parallel electrically conductive wires along two intersecting directions to form a plurality of apertures. In further specific embodiments, the top ground plate 68b is an electrically conductive wire screen having from about 5% to about 60% of the footprint of a similarly sized solid top ground plate 68a such as that illustrated in FIG. 2. As illustrated, the top ground plate 68b may have a round cross-section and a circular perimeter characteristic of a disk geometrical shape when viewed in a direction normal to plate 68b. The probe pin 16 projects beyond a plane of the top ground plate 68a toward the bottom ground plate 14 and is electrically isolated from the top ground plate 68b.

Advantageously, and as illustrated in FIG. 3, the top ground plate 68b is configured as a wire screen such that the parasitic capacitance between the top ground plate 68b and the probe pin 16 is reduced, and such that the electromagnetic field produced when the probe pin 16 and/or the IC 12 is charged, and/or when the probe pin 16 and/or IC 12 that has been charged is discharged is shaped. Furthermore, the top ground plate 68b may be configured as a wire screen to reduce the parasitic capacitance between the bottom ground plate 14 and the IC 12, as the top ground plate 68b includes a plurality of apertures.

Those skilled in the art will recognize that the environments illustrated in FIGS. 1-3 are not intended to limit the embodiments of the present invention. Indeed, those having skill in the art will recognize that other alternative hardware environments may be used without departing from the scope of the invention. For example, the system 10 may include additional computers, controllers, or measuring components.

In an alternative embodiment and as shown in FIG. 1A in which like reference numerals refer to like features in FIG. 1, the system 10 may omit the oscilloscope 52 and may instead include a 50Ω resistor 92 so that the controller 20 receives the electrostatic discharge signals directly from the attenuator 54. As such, the controller 20 may be configured to determine the TPCDM response of the IC 12 through software, such as application 38, that may be configured as a computer-based oscilloscope as is well known in the art.

Additionally, one having ordinary skill in the art will recognize that the environment for the controller 20 is not intended to limit the scope of embodiments of the invention. Though not shown, for instance, one skilled in the art will appreciate that more than one controller 20 may be included within other embodiments of the system 10 without departing from the scope of the invention.

The routines executed to implement the embodiments of the invention, whether implemented as part of an operating system or a specific application, component, program, object, module or sequence of instructions executed by at least one processing unit 22 will be referred to herein as "computer program code," or simply "program code." The program code typically comprises one or more instructions that are resident at various times in various memory and storage devices in the controller 20, and that, when read and executed by one or more processing units 22 of the controller 20 cause that controller 20 to perform the steps necessary to execute steps, elements, and/or blocks embodying the various aspects of the invention.

While the invention has and hereinafter will be described in the context of fully functioning systems, those skilled in the art will appreciate that the various embodiments of the invention are capable of being distributed as a program product in a variety of forms, and that the invention applies equally regardless of the particular type of computer readable signal bearing media used to actually carry out the distribution. Examples of computer readable signal bearing media include but are not limited to recordable type media such as volatile and nonvolatile memory devices, floppy and other removable disks, hard disk drives, optical disks (e.g., CD-ROM's, DVD's, etc.), among others, and transmission type media such as digital and analog communication links.

In addition, various program code described hereinafter may be identified based upon the application or software component within which it is implemented in a specific embodiment of the invention. However, it should be appreciated that any particular program nomenclature that follows is used merely for convenience, and thus the invention should not be limited to use solely in any specific application identified and/or implied by such nomenclature. Furthermore, given the typically endless number of manners in which computer programs may be organized into routines, procedures, methods, modules, objects, and the like, as well as the various manners in which program functionality may be allocated among various software layers that are resident within a typical computer (e.g., operating systems, libraries, APIs, applications, applets, etc.), it should be appreciated that the invention is not limited to the specific organization and allocation of program functionality described herein.

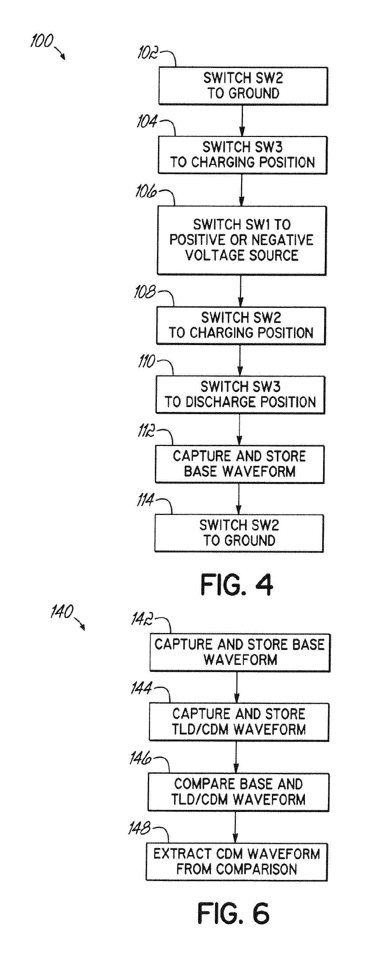

TPCDM ESD tests consistent with embodiments of the invention may be used to test integrated circuit devices to determine the CDM characteristics of those devices when they acquire a charge (e.g., for example, through a triboelectric and/or electrostatic induction process) and then touch a grounded object or surface. For example, by measuring a base waveform (e.g., a transmission path ESD signal from a charged transmission path to an IC), measuring a TLD and CDM waveform ("TLD/CDM" waveform) (e.g., a transmission path and charged IC signal from a charged transmission path and charged IC), and determining a CDM waveform (e.g., a charged IC ESD signal) based upon the base and TLD/CDM waveforms, the CDM characteristics of an IC may be determined. FIG. 4 is a flowchart 100 illustrating a process that may be executed by a controller to capture a base waveform that may include the transmission path ESD signals of a system consistent with embodiments of the invention. The controller may switch a second switch ("SW2") to electrically connect a first input of SW2 with an electrical ground (block 102) and switch a third switch ("SW3") to a charging position (block 104) to electrically connect a first input of SW3 with the output of SW2, and thus to the electrical ground. In some embodiments, the output of SW3 is electrically connected to a transmission path that in turn may be used for TPCDM testing of an IC.

Before charging the transmission path, the controller may determine whether to charge the transmission path with a positive or negative voltage source. For example, program code of the controller may be configured to charge the transmission path with a positive or negative voltage, or the controller may be controlled by a user to charge the transmission path with a positive or negative voltage. In some embodiments, a high voltage power supply unit (HVPSU) includes one positive voltage source and one negative voltage source, and the controller may control a first switch ("SW1") to choose between the positive and negative voltage switch. In specific embodiments, the positive voltage source of the HVPSU may be connected to a first input of SW1, and the negative voltage source of the HVPSU may be connected to a second input of SW1. In alternative embodiments, the positive voltage source of the HVPSU may be connected to the second input of SW1, and the negative voltage source of the HVPSU may be connected to the first input of SW1. As such, the controller may switch the SW1 to the positive or negative voltage source based upon the controller or user (block 106). In turn, the output of SW1 may be in electrical communication with a second input of SW2 such that, when SW2 is switched from the first input and the connection to the electrical ground to the second input and the connection to the HVPSU, SW2 is switched to a charging position (block 108). When SW2 and SW3 are in the charging positions, the transmission path may be charged by the HVPSU. In specific embodiments, the transmission path may be charged by the HVPSU for a period of time greater than 50 milliseconds.

After charging the transmission path, the controller may switch SW3 to a discharge position (block 110) by switching from the first input of SW3 to a second input of SW3, which may be in electrical communication with an oscilloscope through at least one attenuator. As such, the charge on the transmission path may be discharged to the oscilloscope, and the controller may control the oscilloscope to capture and store the base waveform produced by the transmission path (block 112). Alternatively, the electrostatic discharge signal from the transmission path may be supplied directly to the controller and stored by the controller for future use. The controller may then switch SW2 back to the first input, thus electrically connecting the output of SW2 to the electrical ground (block 114).

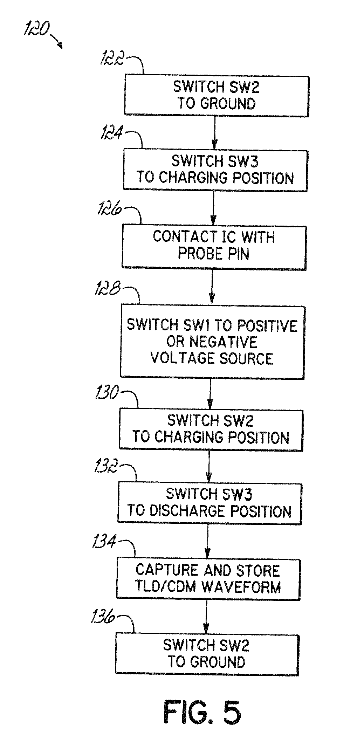

Once the base waveform has been captured, the system may capture the TLD/CDM waveform from the signal line and IC. FIG. 5 is a flowchart 100 illustrating a process that may be executed by the controller to capture the TLD/CDM waveform consistent with embodiments of the invention. The controller may switch SW2 to electrically connect the first input of SW2 with the electrical ground (block 122) and switch SW3 to the charging position (block 124) to electrically connect the first input of SW3 with the output of SW2, and thus to the electrical ground. The controller may then control an actuator to move a support arm holding a top ground plate and probe pin to electrically connect the IC to the system through a probe pin in electrical connection with the transmission path (block 126).

Before charging the transmission path and IC, the controller may determine whether to charge the signal line with a positive or negative voltage source. For example, program code of the controller may be configured to charge the transmission path and the IC with a positive or negative voltage, or the controller may be controlled by a user to charge the transmission path and the IC with a positive or negative voltage. As such, the controller may switch the SW1 to the positive or negative voltage source based upon the controller or user (block 128). In turn, the output of SW1 may be in electrical communication with the second input of SW2 such that, when SW2 is switched from the first input and the connection to the electrical ground to the second input and the connection to the HVPSU, SW2 is switched to a charging position (block 130). When SW2 and SW3 are in the charging positions, the transmission path and the IC may be charged by the HVPSU. In specific embodiments, the transmission path and the IC may be charged by the HVPSU for a period of time greater than 50 milliseconds.

After charging the transmission path and the IC, the controller may switch SW3 to a discharge position (block 132) by switching from the first input of SW3 to the second input of SW3, which may be in electrical communication with the oscilloscope through at least one attenuator. As such, the charge on the transmission path and the IC may be discharged to the oscilloscope, and the controller may control the oscilloscope to capture and store the TLD/CDM waveform produced by the charged transmission path and charged IC (block 134). Alternatively, the electrostatic discharge signal from the transmission path and the IC may be supplied directly to the controller and stored by the controller for future use. The controller may then switch SW2 back to the first input, thus electrically connecting the output of SW2 to the electrical ground (block 136).

To determine the CDM characteristics of an IC, the base waveform may be compared to the TLD/CDM waveform and a CDM waveform illustrating the CDM characteristics of the IC may be determined by either the oscilloscope or the controller depending upon the structural configuration of the system. FIG. 6 is a flowchart 140 illustrating a process that may be executed to determine the CDM waveform based on the base waveform and the TLD/CDM waveform consistent with embodiments of the invention. To determine the CDM waveform, a base waveform may be captured (block 142) consistent with embodiments of the process illustrated in FIG. 4. Returning to FIG. 6, a TLD/CDM waveform may be captured (block 144) consistent with embodiments of the process illustrated in FIG. 5. Again returning to FIG. 6, the base waveform may be compared to the TLD/CDM waveform (block 146) by the oscilloscope or controller. In some embodiments, the base waveform is a waveform that includes a transmission path ESD signal from a charged transmission path. In some embodiments, the TLD/CDM waveform is a waveform that includes the transmission path ESD signal and a charged device ESD signal from the charged transmission path and a charged IC, respectively. Thus, by comparing the base waveform and the TLD/CDM waveform (block 146), the CDM waveform that includes a charged IC ESD may be extracted (block 148), and the CDM characteristics of the IC may be determined. In specific embodiments, the controller or oscilloscope may extract the CDM waveform from the compared base and TLD/CDM waveforms by subtracting the values of the base waveform from the corresponding values of the TLD/CDM waveform. For example, the base waveform and TLD/CDM waveform may be sampled with a particular number of samples per second. By aligning the beginning of the base waveform and the beginning of the TLD/CDM waveform, then subtracting the values of the base waveform from the corresponding values of the TLD/CDM waveform at corresponding times, the CDM waveform that includes the charged IC ESD may be extracted.

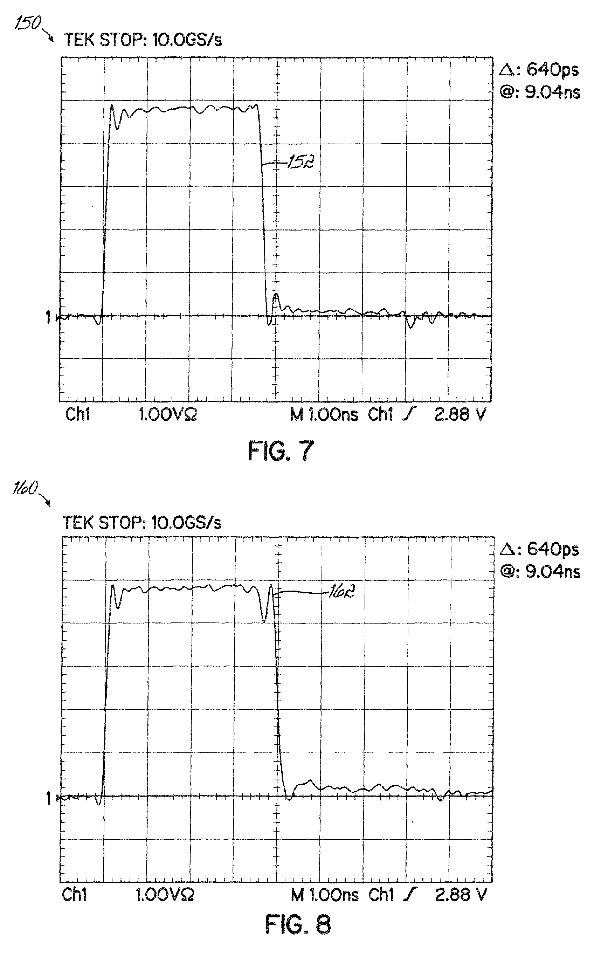

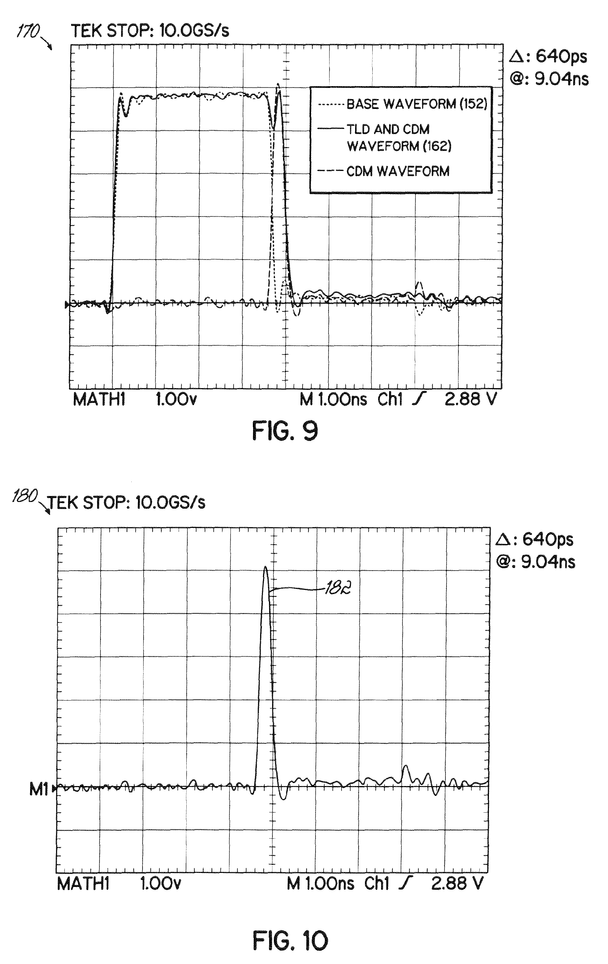

FIG. 7 is a diagrammatic illustration 150 of a trace of the base waveform 152 as captured by the oscilloscope or controller consistent with embodiments of the invention. The base waveform 152 includes the transmission path ESD signal of the charged transmission path and may be used to determine the CDM characteristics of the IC. FIG. 8, on the other hand, is a diagrammatic illustration 160 of a trace of the TLD/CDM waveform 162 as captured by the oscilloscope or controller consistent with embodiments of the invention. The TLD/CDM waveform 162 includes the transmission path ESD signal of the charged transmission path as well as the charged IC ESD signal from the charged IC. FIG. 9 is a diagrammatic illustration 170 of a comparison of the base waveform (in a dotted line), and the TLD/CDM waveform 162 (in a solid line). As illustrated, substantial portions of the base waveform 152 and TLD/CDM waveform 162 overlap. Although minute variations exist between the base waveform 152 and TLD/CDM waveform 162, they both reflect the transmission path ESD signal of the charged transmission path, while the TLD/CDM waveform 162 additionally reflects the charged IC ESD signal from the charged IC. Moreover, FIG. 9 illustrates the CDM waveform that includes the charged IC ESD signal from the charged IC with a dashed line, while FIG. 10 is a diagrammatic illustration 180 of the CDM waveform 182 as extracted from the base waveform 152 and TLD/CDM waveform 162. FIG. 9 illustrates that the CDM waveform 182 (in a dashed line) may be extracted from the base waveform 152 and TLD/CDM waveform 162 by subtracting the base waveform 152 from the TLD/CDM waveform 162, while FIG. 10 illustrates the extracted CDM waveform 182 in isolation. For the waveforms 152, 162, 182, the representative sample rate is 10GS/s and the vertical scale is express in as a signal amplitude in volts.

While embodiments of the present invention have been illustrated by a description of the various embodiments, and while these embodiments have been described in considerable detail, it is not the intention of the Applicant to restrict or in any way limit the scope of the appended claims to such detail. Additional advantages and modifications will readily appear to those skilled in the art. Thus, the invention in its broader aspects is therefore not limited to the specific details, representative apparatus and method, and illustrative example shown and described. In particular, any of the blocks of the above flowcharts may be deleted, augmented, made to be simultaneous with another, combined, or be otherwise altered in accordance with the principles of the present invention. Moreover, one having ordinary skill in the art will appreciate that a user, rather than the controller, may manually control some or all of the switches of the system (e.g., SW1, SW2, and/or SW3) without departing from the scope of the invention. Accordingly, departures may be made from such details without departing from the scope of Applicant's general inventive concept.

## Claims

1. A method of testing an integrated circuit device, the method comprising:
measuring a first electrostatic discharge signal from a charged transmission path;
measuring a second electrostatic discharge signal from the charged transmission path and a charged integrated circuit device coupled with the charged transmission path; and
determining a charged device model (CDM) waveform based upon the first and second electrostatic discharge signals.

2. The method of claim 1 wherein the first electrostatic discharge signal is contained in a first waveform, the second electrostatic discharge signal is contained in a second waveform, and determining the CDM waveform comprises:
removing the first waveform from the second waveform to yield the CDM waveform.

3. The method of claim 2 wherein removing the first waveform from the second waveform comprises:
subtracting the first waveform from the second waveform at corresponding times relative to a initial time for each respective measurement to yield the CDM waveform.

4. The method of claim 1 wherein measuring the first electrostatic discharge signal comprises:
charging the transmission path;
discharging the transmission path; and
in response to discharging the transmission path, measuring the first electrostatic discharge signal.

5. The method of claim 4 wherein measuring the second electrostatic discharge signal comprises:
electrically coupling the integrated circuit device with the transmission path;
concurrently charging the transmission path and the integrated circuit device;
concurrently discharging the transmission path and the integrated circuit device; and
in response to discharging the transmission path and the integrated circuit device, measuring the second electrostatic discharge signal;.

6. The method of claim 1 wherein measuring the second electrostatic discharge signal comprises:
electrically coupling the integrated circuit device with the transmission path;
concurrently charging the transmission path and the integrated circuit device;
concurrently discharging the transmission path and the integrated circuit device; and
in response to discharging the transmission path and the integrated circuit device, measuring the second electrostatic discharge signal;

7. The method of claim 1 wherein measuring the first electrostatic discharge signal further comprises:
directing the first electrostatic discharge signal through at least one attenuator to an oscilloscope capable of determining the CDM waveform or to a controller capable of determining the CDM waveform.

8. The method of claim 7 wherein measuring the second electrostatic discharge signal further comprises:
directing the second electrostatic discharge signal through the at least one attenuator to the oscilloscope or to the controller.

9. A system to test an integrated circuit device, the system comprising:
a first electrically conductive plate in electrical communication with electrical ground and configured to support the integrated circuit device;
a second electrically conductive plate in electrical communication with the electrical ground;
a probe pin in electrical communication with a transmission path to electrically communicate with the integrated circuit device;
a support arm operable to electrically couple the probe pin to the integrated circuit device and to support the second electrically conductive plate and the probe pin; and
a controller coupled with the probe pin and support arm, the controller configured to charge the transmission path of the system, discharge the transmission path, and measure a first electrostatic discharge signal, to move the support arm to electrically couple the integrated circuit device with the transmission path, charge the transmission path and the integrated circuit device, discharge the transmission path and the integrated circuit device, and measure a second electrostatic discharge signal from which the first electrostatic discharge signal can be removed to determine a charged device model (CDM) waveform.

10. The system of claim 9 wherein the second electrically conductive plate is a solid plate, and the probe pin projects a location peripherally inside the solid plate toward the first electrically conductive plate.

11. The system of claim 9 wherein the first electrically conductive plate is a wire screen having a plurality of substantially parallel wires along two intersecting directions to define a plurality of apertures, and the probe pin projects from the wire screen toward the first electrically conductive plate.

12. The system of claim 9 further comprising:
a high voltage power supply unit; and
a switch configured to selectively couple the high voltage power supply unit with the transmission line, the switch having a first position for electrically connecting the transmission path with the high voltage power supply unit to charge the transmission path and a second position in which the transmission line is disconnected from the high voltage power supply unit to discharge the transmission path for measuring the first and second electrostatic discharge signals.

13. The system of claim 12 further comprising:
an oscilloscope coupled by the switch in the second position to define a signal line with the transmission path, the oscilloscope configured to determine the waveform by removing the first electrostatic discharge signal from the second electrostatic discharge signal and further comprising:
at least one attenuator in the signal line between the oscilloscope and the switch.

14. The system of claim 13 wherein the at least one attenuator is configured to cause a 40dB attenuation of the first and second electrostatic discharge signals to the oscilloscope.

15. The system of claim 12 wherein the controller is coupled by the switch in the second position with the transmission path, the controller configured to determine the waveform by removing the first electrostatic discharge signal from the second electrostatic discharge signal and further comprising:
at least one attenuator in the signal line between the oscilloscope and the switch; and
a resistor in the signal line between the at least one attenuator and the controller.
